# EUROPÄISCHE PATENTSCHRIFT

(11) **EP 3 631 983 B1**
(45) Veröffentlichungstag und Bekanntmachung des Hinweises auf die Patenterteilung: **29.04.2026**
(21) Anmeldenummer: 18717048.5
(22) Anmeldetag: 11.04.2018
(51) Int. Cl.: H03G 7/00, H03F 1/52, H03G 7/08

(54) **VERFAHREN ZUM ÜBERTEMPERATURSCHUTZ UND AUDIOEINRICHTUNG**
METHOD FOR OVERTEMPERATURE PROTECTION AND AUDIO APPARATUS
PROCÉDÉ DE PROTECTION CONTRE LES SURCHAUFFES ET DISPOSITIF AUDIO

(30) Priorität: 30.05.2017 DE 102017209072
(43) Veröffentlichungstag der Anmeldung: 08.04.2020
(73) Patentinhaber: Robert Bosch GmbH, 70442 Stuttgart (DE)
(72) Erfinder: HOFFMEISTER, Fabian, 84337 Schoenau (DE); STEIN, Thomas, 93192 Wald (DE); SAUER, Gregor, 35510 Butzbach-Griedel (DE); ENGL, Patrick, 94372 Rattiszell (DE); PLAGER, Josef, 94327 Bogen (DE)
(74) Vertreter: Winter, Brandl - Partnerschaft mbB
(86) Internationale Anmeldenummer: PCT/EP2018/059281
(87) Internationale Veröffentlichungsnummer: WO 2018/219542

(56) Entgegenhaltungen:
- WO-A1-2016/124896
- WO-A1-2016/124897
- US-A- 6 014 059
- US-A1- 2016 119 714
- US-A1- 2016 119 714
- US-A1- 2017 094 408
- US-A1- 2017 094 408

## Beschreibung

### Stand der Technik

Um in elektronischen Geräten und Schaltungen, z.B. in Audiogeräten, die Zuverlässigkeit gewährleisten zu können, müssen alle verwendeten Komponenten innerhalb des Audiogerätes, z.B. Halbleiter, innerhalb des so genannten sicheren Betriebsbereiches (SOA, Safe Operating Area) betrieben werden. Im Wesentlichen beschreibt die SOA die Menge an Verlustleistung, die der Komponente, z.B. dem Bauteil, zugemutet werden kann, ohne dass diese beschädigt wird. Außerhalb dieses Bereiches wird die Komponente, z.B. der Halbleiter, überlastet, was zu deren Zerstörung führen würde.

Aus der EP 0 135 870 A1 ist ein Verfahren zur Überlastsicherung elektrischer Leistungsverbraucher bekannt, bei dem Verbraucherstrom und Temperatur des am Leistungsverbraucher wirkenden Kühlmittels periodisch gemessen und die nach jeder Periode gemessenen Werte von Strom und Temperatur einer Schaltungsanordnung zugeführt werden, in der sie zur Nachbildung einer Temperatur nach dem Algorithmus eines thermischen Systems verarbeitet werden und die nachgebildete Temperatur mit einer vorgegebenen Grenztemperatur verglichen wird, oberhalb derer ein Schalter zur Unterbrechung des Verbraucherstroms betätigt wird. Dem Leistungsverbraucher ist mindestens ein thermisches System mit jeweils mindestens zwei Systemkörpern zugeordnet. Die Verluste der Systemkörper des thermischen Systems werden periodisch ermittelt. Aus den derart ermittelten Verlusten, dem periodisch zugeordneten Wert der Kühlmitteltemperatur sowie den Wärmekapazitäten und

Wärmeleitwerten der Systemkörper des thermischen Systems wird die Temperatur jedes Systemkörpers des thermischen Systems ermittelt und die derart ermittelte Temperatur jedes zu schützenden Systemkörpers des thermischen Systems wird fortlaufend mit der diesem Systemkörper zugeordneten Grenztemperatur verglichen.

Aus der WO 2016/124896 A1 ist ein Lautsprecherschutz bekannt. Dabei bestimmt ein Verstärkungs-Steuerungs-Block, basierend auf einem thermischen Impedanzmodell und einem vorhergesagten Temperaturanstieg, ob eine Temperatur eine oder mehrere Schwellen übersteigt oder übersteigen wird.

Aus der US 2017/0094408 A1 ist ein thermischer Schutz eines Lautsprechers bekannt. Eine Steuerung erzeugt ein Steuersignal für die Verstärkung des Lautsprechertreibers. Das Steuersignal ist eine Funktion von: einem Hinweis auf die Sprachspulentemperatur des Lautsprechers, einem Hinweis auf die Leistungsaufnahme in der Sprachspule des Lautsprechers, einem Hinweis auf eine Temperatur eines thermischen Reservoirs für einen Wärmefluss von der Sprachspule.

Aus dem US Patent 6,014,059 ist ein Leistungsverstärker mit einem Verstärkungstransistor bekannt. Ein Modul steuert das Eingangssignal des Verstärkers. Ein Modul erzeugt ein Steuersignal, welches der Temperatur eines Transistors in einem Temperaturbereich folgt. Das Steuersignal übersteigt dabei einen vorbestimmten Wert nicht. Der Wert entspricht einer vorbestimmten Temperatur des Transistors gleich oder unterhalb einer Maximaltemperatur des Transistors.

Aus der US 2016/0119714 A1 ist ein System und ein Verfahren zur Audio-Leistungsbegrenzung, basierend auf thermischer Modellierung, bekannt.

### Offenbarung der Erfindung

Im Rahmen der Erfindung wird ein Verfahren mit den Merkmalen des Anspruchs 1 offenbart. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Das Verfahren dient zum Schutz einer Komponente. Die Komponente befindet sich innerhalb eines Audiogerätes. Die Komponente wird davor geschützt, dass eine Interntemperatur innerhalb der Komponente eine maximale Interntemperatur bzw. einen Maximalwert überschreitet. Die Interntemperatur ist dabei einer insbesondere direkten Messung nicht zugänglich, da es sich um eine Sperrschichttemperatur innerhalb eines Halbleiters als Komponente handelt.

Bei dem Verfahren wird die Verlustleistung der Komponente ermittelt. Weiterhin wird eine Messtemperatur an der Komponente gemessen. "An der Komponente" bedeutet an einem messtechnisch zugänglichen Messort der Komponente oder in deren Umgebung, der thermisch mit der Interntemperatur gekoppelt ist, aus dem sich also auf die Interntemperatur schließen lässt. Ein Messort ist insbesondere ein elektrischer Anschluss der Komponente, ein Kühlkörper, mit dem die Komponente thermisch gekoppelt ist, ein Gehäuseabschnitt der Komponente usw.

Ausgehend von der Verlustleistung wird eine Temperaturdifferenz für die Komponente ermittelt. Die Temperaturdifferenz besteht zwischen der Messtemperatur an der Komponente und der Interntemperatur innerhalb der Komponente. Die Temperaturdifferenz wird mit Hilfe eines thermischen Modells der Komponente ermittelt. Die Interntemperatur wird dann als Summe der Messtemperatur und der Temperaturdifferenz ermittelt.

Anhand der Interntemperatur und anhand bekannter Komponentendaten der Komponente wird ein zulässiger Maximalwert für die Verlustleistung ermittelt. Bei diesem Maximalwert der Verlustleistung wird bekanntermaßen, das heißt gemäß der bekannten Komponentendaten bzw. des Komponentenverhaltens, die maximal zulässige bzw. gewünschte Interntemperatur erreicht (die Interntemperatur erreicht ihren Maximalwert), bei der insbesondere die Komponente noch ohne Zerstörungsgefahr betrieben werden darf.

Gemäß dem Verfahren wird insbesondere die Ausgangsleistung derart reduziert, so dass der (temperaturabhängige) Maximalwert der Verlustleistung nie überschritten wird.

Insbesondere wird die Komponente dann in einem Normalbetrieb betrieben, wenn die Verlustleistung den Maximalwert nicht übersteigt. Alternativ, das heißt wenn die Verlustleistung den Maximalwert übersteigen würde, wird die Komponente in einem leistungsreduzierten Sparbetrieb betrieben. Der Sparbetrieb erfolgt derart leistungsreduziert, dass die Verlustleistung auf den Maximalwert begrenzt wird.

Insbesondere bei einem Halbleiter ist die maximal zulässige Verlustleistung abhängig von der internen Sperrschichttemperatur. Mit der ermittelten Sperrschichttemperatur kann somit zu jedem Zeitpunkt die maximal zulässige Verlustleistung der zu schützenden Komponente ermittelt werden. Mit dem hier vorgestellten Verfahren wird bei einer drohenden Überlastung der zu schützenden Komponente das Audiosignal, insbesondere das Ausgangssignal des Audiogerätes, und damit die Ausgangsleistung derart reduziert, dass die maximal zulässige Verlustleistung der Komponente nicht überschritten wird.

Bei der ermittelten maximalen Verlustleistung wird also die maximale Interntemperatur innerhalb der Komponente gerade eben erreicht, jedoch nicht überschritten. Gemäß dem Verfahren wird die Verlustleistung also nur für den Fall begrenzt, dass diese den zulässigen Maximalwert übersteigt, was zu einer Erhöhung der Interntemperatur über den maximal zulässigen Wert der Interntemperatur führen würde. Insbesondere wird im Sparbetrieb also die Leistung an der Komponente gegenüber einem regulären Normalbetrieb gesenkt, wodurch auch deren Verlustleistung sinkt. Wird der Maximalwert nicht überschritten, wird die Komponente ohne Einschränkung betrieben.

Die Komponentendaten sind insbesondere aus zum Beispiel einem Datenblatt der Komponente bekannt. Der "Maximalwert" der Verlustleistung kann der physikalisch zulässige Wert sein, bei dessen Überschreiten eine unmittelbare Zerstörung des Bauteils droht. Der Maximalwert kann aber auch ein niedrigerer gewünschter Maximalwert sein, wenn die maximal physikalisch zulässige Interntemperatur in der Komponente nicht voll ausgeschöpft werden soll, sondern z.B. nur zu 80, 90 oder 95 % dieser Temperatur betragen soll oder zum Beispiel 10, 15 oder 20 Grad unterhalb dieser Temperatur gehalten werden soll. Somit verbleibt eine gewisse Sicherheitsreserve, um die Komponente vor Zerstörung zu schützen.

Gemäß dem Verfahren erfolgt also weiterhin ein wenn auch eingeschränkter (Spar-)Betrieb der Komponente und damit des Audiogerätes, auch wenn die Interntemperatur bei einem regulären Normalbetrieb ihren Maximalwert erreicht oder sich diesem nähert, es erfolgt lediglich eine Leistungsbegrenzung der Verlustleistung in der Komponente und damit zum Beispiel auch einer Ausgangsleistung der Komponente bzw. des Audiogerätes. Das Audiogerät bleibt aber weiterhin im Betrieb und muss nicht vollständig abgeschaltet werden.

Gemäß der Erfindung liefert ein Audiogerät in Form eines Verstärkers z.B. volle Ausgangsleistung (Normalbetrieb) für z.B.4min, dann wird die maximale Ausgangsleistung begrenzt (Sparbetrieb). Dabei ist z.B. eine Reduzierung um 3dB wahrnehmbar, aber nicht überdeutlich, wobei dies eine Halbierung der Ausgangsleistung bedeutet, wodurch die Leistungselektronik deutlich entlastet wird. Es wird also die Grundfunktion aufrechterhalten im Gegensatz zu einer Abschaltung.

In einer bevorzugten Ausführungsform wird die Verlustleistung dadurch ermittelt, dass die Ausgangsleistung der Komponente ermittelt wird und die Verlustleistung anhand der Ausgangsleistung und der bekannten Komponentendaten ermittelt wird. Die Ausgangsleistung ist in der Regel einfacher bestimmbar als die Verlustleistung, zum Beispiel anhand von Ausgangsspannung und/oder Ausgangsstrom einer Komponente. Die Komponentendaten, die hierzu herangezogen werden, sind zum Beispiel Bauteileigenschaften oder Betriebsspannungen an der Komponente. So lässt sich die Verlustleistung indirekt, aber aufgrund der Verknüpfung mit den Komponentendaten ermitteln. Alternativ kann auch eine Eingangsleistung oder eine sonstige Größe ermittelt werden, aus der aufgrund der bekannten Komponentendaten auf die (interne) Verlustleistung der Komponente geschlossen werden kann.

In einer bevorzugten Ausführungsform wird die Verlustleistung auch anhand der Interntemperatur und/oder der Messtemperatur ermittelt. Beide Temperaturen können einen Einfluss auf die Verlustleistung in der Komponente haben. Eine Berücksichtigung der entsprechenden Temperaturen führt somit zu einer genaueren Ermittlung der Verlustleistung und damit einer genaueren Abstimmung des Normal- und Sparbetriebes auf die anhand des Maximalwertes vorgegebenen Leistungsgrenze für die Verlustleistung.

In einer bevorzugten Ausführungsform wird im thermischen Modell mindestens eine thermische Zeitkonstante verwendet. Die Zeitkonstante beschreibt ein dynamisches thermisches Verhalten einer thermischen Strecke. Die thermische Strecke besteht zwischen dem Ort der Interntemperatur (wo diese auftritt bzw. vorhanden ist) und dem Messort der Messtemperatur (an dem die Messtemperatur gemessen wird). Durch ein derartiges thermisches Modell kann besonders sicher und zuverlässig von der Messtemperatur auf die Interntemperatur geschlossen werden.

In einer bevorzugten Ausführungsform wird aus dem Maximalwert für die zulässige Verlustleistung ein Maximalwert für eine zulässige Ausgangsleistung der Komponente ermittelt. Dies erfolgt entsprechend zu oben anhand der Komponentendaten. Im leistungsreduzierten Sparbetrieb wird die Komponente so betrieben, dass die Ausgangsleistung auf den zugehörigen Maximalwert (für die Ausgangsleistung) begrenzt wird. Die Ausgangsleistung der Komponente ist in der Regel besser oder direkt bzw. unmittelbar steuerbar als die Verlustleistung. Beispielsweise wird die Ausgangsleistung an der Komponente durch einen Strom und/oder eine Spannung an der Komponente bestimmt. Dieser Strom und diese Spannung können z.B. in einfacher Weise beeinflusst bzw. gesteuert werden. So ist das Verfahren besonders einfach durchführbar.

In einer bevorzugten Ausführungsform wird im Sparbetrieb die Verlustleistung mit Hilfe eines Audiolimiters auf den Maximalwert begrenzt. Der Audiolimiter ist hierbei in einem Audiopfad stromaufwärts der Komponente angeordnet. Auf dem Audiopfad wird ein Audiosignal geführt und (zumindest ein Teilsignal dessen) wird der Komponente als Eingangssignal zugeführt. Die Begrenzung erfolgt, in dem das Audiosignal als Eingangssignal gegenüber seinem Verlauf im Normalbetrieb begrenzt wird. Audiolimiter sind insbesondere einfach zu realisieren bzw. auf dem Markt verfügbar. Durch den Einsatz des Audiolimiters kann das Verfahren besonders einfach durchgeführt werden. Indem das Audiosignal begrenzt wird, wird insbesondere dessen "Lautstärke" bzw. Amplitude abgesenkt, die Komponente, z.B. ein Endstufenverstärker, benötigt dann weniger Leistung zu dessen Bearbeitung und erzeugt damit auch weniger Verlustleistung.

Im Rahmen der Erfindung wird auch eine Audioeinrichtung gemäß Patentanspruch 7 offenbart. Diese enthält ein Audiogerät. Innerhalb des Audiogerätes ist eine Komponente enthalten. Die Komponente ist - wie oben erläutert - vor dem Überschreiten einer maximalen Interntemperatur innerhalb der Komponente zu schützen. Die Audioeinrichtung enthält ein Schutzmodul. Das Schutzmodul dient zur Ausführung des erfindungsgemäßen Verfahrens bzw. ist hierzu eingerichtet. Die Audioeinrichtung und zumindest ein Teil deren Ausführungsformen sowie die jeweiligen Vorteile wurden sinngemäß bereits im Zusammenhang mit dem erfindungsgemäßen Verfahren erläutert. Dem Audiogerät ist also ein Schutzmodul zugeordnet, um die Komponente, die vor dem Überschreiten einer maximalen Interntemperatur zu schützen sind, wobei die Interntemperatur einer direkten Messung nicht zugänglich ist, wobei die Komponente ein zu schützendes Halbleiterbauteil enthält oder ist, und die Interntemperatur eine Sperrschichttemperatur im Halbleiterbauteil ist, gemäß dem oben erläuterten Verfahren zu schützen. Mit anderen Worten ist die Audioeinrichtung ein um das Schutzmodul modifiziertes Audiogerät. Das Schutzmodule ist zur Ausführung des folgenden Verfahrens eingerichtet:
- Ermittlung einer Verlustleistung der Komponente,
- Messung einer Messtemperatur an der Komponente, an einem messtechnisch zugänglichen Messort der Komponente oder in deren Umgebung, der thermisch mit der Interntemperatur gekoppelt ist,
- Ermittlung einer Interntemperatur innerhalb der Komponente mit Hilfe eines thermischen Modells der Komponente ausgehend von der ermittelten Verlustleistung und der gemessenen Messtemperatur,
- Ermittlung eines zulässiger Maximalwert für die Verlustleistung anhand der Interntemperatur und bekannter Komponentendaten der Komponente,
- Begrenzung eines Audiosignal derart, so dass die Verlustleistung einen Maximalwert nicht übersteigt und/oder die maximale Interntemperatur nicht überschritten wird.

In einer bevorzugten Ausführungsform ist das Audiogerät und/oder die Audioeinrichtung ein Audioverstärker zur Verstärkung des oben genannten Audiosignals. Der Audioverstärker ist insbesondere eine Endstufe. Audioverstärker sind in der Regel besonders anfällig für Zerstörung enthaltener Komponenten durch interne Übertemperaturen. Durch das vorliegende Verfahren bzw. das Schutzmodul sind diese besonders effektiv geschützt.

In einer bevorzugten Ausführungsform enthält die Komponente ein zu schützendes Halbleiterbauteil oder ist ein zu schützendes Halbleiterbauteil. Die Interntemperatur ist dann eine Sperrschichttemperatur im Halbleiterbauteil. Insbesondere Halbleiterbauteile sind bezüglich deren Sperrschicht besonders temperaturempfindlich. Durch das vorliegende Verfahren bzw. Schutzmodul werden diese besonders effektiv vor Zerstörung geschützt.

Alternativ kann die Komponente jedoch auch enthalten: einen Kondensator, eine Induktivität, ein Relais, einen Widerstand, einen Motor. Die Komponente kann aber auch eine Baugruppe aus mehreren Einzelbauteilen sein. Die Einzelbauteile sind dann z.B. wieder die genannten Halbleiter, Kondensatoren, Induktivitäten usw. Auch diese Komponenten können besonders verlustleistungs- bzw. temperaturempfindlich sein und sind durch das vorliegende Verfahren bzw. Schutzmodul besonders effektiv geschützt.

In einer bevorzugten Ausführungsform enthält das Schutzmodul einen Audiolimiter, wie er oben beschrieben wurde. Der Audiolimiter ist in einem Audiopfad stromaufwärts des Audiogerätes angeordnet. Auf dem Audiopfad wird ein Audiosignal geführt und dem Audiogerät und somit auch der Komponente als Eingangssignal zugeführt. Der Audiolimiter ist dazu eingerichtet, das Audio-Eingangssignal in das Audiogerät im Sparbetrieb zu begrenzen. Der Audiolimiter ist somit im Audiopfad auch stromaufwärts der Komponente angeordnet, wodurch sich die oben genannten Vorteile ergeben.

Die Erfindung beruht auf folgenden Erkenntnissen, Beobachtungen bzw. Überlegungen und weist noch die nachfolgenden Ausführungsformen auf. Die Ausführungsformen werden dabei teils vereinfachend auch "die Erfindung" genannt. Die Ausführungsformen können hierbei auch Teile oder Kombinationen der oben genannten Ausführungsformen enthalten oder diesen entsprechen und/oder gegebenenfalls auch bisher nicht erwähnte Ausführungsformen einschließen.

Die Erfindung gründet sich auf folgende Überlegungen: Das Sicherstellen des Betriebs einer Komponente innerhalb der SOA kann auf unterschiedliche Weise erfolgen: Z.B. wird in einem Gerät bei einem Teil der verwendeten Halbleiter (als Komponenten) durch das Design selbst das Betreiben innerhalb der SOA sichergestellt, und ein Anwender hat auf die Beanspruchung des Halbleiters keinen oder kaum Einfluss. Gerade in der Leistungselektronik gibt es aber oft den Fall, dass je nach Betriebsart die Belastung einzelner Halbleiter stark variiert. Wenn der Nutzer einen großen Einfluss auf die Beanspruchung dieser einzelnen Komponenten hat, so müssen spezielle Vorkehrungen getroffen werden, um diese Komponenten zu schützen. Eine Auslegung der Komponenten auf den schlimmsten möglichen Fall (z.B. Kurzschluss durch den Anwender) kommt hierbei oft einer völligen Überdimensionierung für den Normalbetrieb gleich. Eine Notabschaltung des Geräts kann zwar in den meisten Fällen die Komponenten schützen, ist aber aus Anwendersicht meist nicht zu bevorzugen.

Eine Grundidee der Erfindung ist es daher, eine drohende Überlastung zu erkennen und mit einer Reduzierung der Ausgangsleistung (bzw. der Verlustleistung) zu reagieren um damit die Temperaturerhöhung zu begrenzen. Eine Idee ist es, die Erkennung einer drohenden Überlastung durch Messung von Ausgangsspannung und Ausgangsstrom der Komponente und/oder mit einem Temperatursensor zu realisieren, welcher an einem Messort in der Nähe der zu schützenden Komponente bzw. des zu schützenden Bauteils platziert wird, z.B. auf demselben Kühlkörper. Es wird also nicht die Temperatur der Komponente (Halbleiter) selbst gemessen, sondern eine Temperatur, die mit der Komponententemperatur (Halbleitertemperatur) möglichst gut thermisch gekoppelt ist. Bei einer statischen Belastung ist der Temperaturunterschied dabei meist recht gering. Tritt jedoch schlagartig eine starke Belastung (bzw. eine potenzielle Überbelastung) auf, so verstreicht eine gewisse Zeit, bis der Messort (z.B. Kühlkörper) erwärmt wird. In dieser Zeit kann die Temperaturdifferenz zwischen der gemessenen Temperatur und der tatsächlichen Komponententemperatur (Halbleitertemperatur) sehr hoch sein. Um also ausschließlich anhand der gemessenen Temperatur die Komponente (Halbleiter) sicher vor Zerstörung schützen zu können, muss eine beachtliche Reserve eingeplant werden um diese dynamischen Belastungen absichern zu können. Das heißt auf der anderen Seite aber auch, dass die statische Maximalleistung deutlich unterhalb der möglichen Ausgangsleistung liegt.

Die Erfindung beruht auf der Erkenntnis, dass die Verlustleistung einer Komponente, z.B. eines Bauteils, durch interne Eigenschaften der Komponente sowie durch äußere Betriebsbedingungen wie Spannung und Strom an der Komponente bestimmt ist. Die Komponenten- bzw. Bauteileigenschaften sind bekannt. Sie sollten vollständig im Datenblatt angegeben sein. Sind auch die äußeren Betriebsbedingungen der Komponente bekannt, so kann die momentane Verlustleistung der Komponente, z.B. des Halbleiters, berechnet werden. Zum Beispiel kann die Betriebsspannung bekannt und konstant sein, und der Strom ist variabel, wird aber gemessen. Wenn die Verlustleistung der zu schützenden Komponente bzw. des Bauteils bekannt ist, so kann mit Hilfe eines thermischen Modells die aktuelle Temperatur in der Komponente, z.B. im Halbleiter, berechnet werden. Wird mit dem thermischen Modell (z.B. Foster-Modell) die Strecke zwischen Komponenten- bzw. Halbleiterinnerem und dem Messort der Temperaturmessung (z.B. Temperatursensor) nachgebildet, so kann die errechnete Erwärmung zu der gemessenen Temperatur addiert werden. Auf diese Weise erhält man die Interntemperatur der Komponente, z.B. Sperrschichttemperatur, der zu schützenden Komponente bzw. des Bauteils. Die Ausgangsleistung kann nun aufgrund der relativ genauen Kenntnis der Intern- bzw. Sperrschichttemperatur innerhalb der Komponente bzw. des Halbleiters reduziert werden. Zusätzlich kann die Information der Interntemperatur bzw. Sperrschichttemperatur in die Verlustleistungsermittlung mit einbezogen werden, soweit diese relevant ist (z.B. RDSON bei einem MOSFET). Somit lassen sich mit den gleichen Komponenten höhere Ausgangsleistungen realisieren bei voller Betriebssicherheit. Andersrum betrachtet können für die gleiche Ausgangsleistung mit diesem Verfahren günstigere Komponenten verwendet werden.

Insbesondere beinhaltet das Verfahren im Wesentlichen somit 5 Eckpunkte:
1. Ermittlung der Verlustleistung der zu schützenden Komponente bzw. des Bauteils,
2. Ermittlung der Temperaturerhöhung mit Hilfe der errechneten Verlustleistung und eines thermischen Modells,
3. Temperaturmessung,
4. Ermittlung der maximal zulässigen Verlust- bzw. Ausgangsleistung,
5. (Gegebenenfalls) Reduzierung der Verlust- bzw. Ausgangsleistung.

Da mit dem genannten Verfahren die maximal zulässige Verlust- bzw.

Ausgangsleistung direkt vom Zerstörungsmechanismus, nämlich der Überhitzung im Inneren der Komponente bzw. des Halbleiters, abgeleitet wird, kann die Unsicherheitsreserve gegenüber herkömmlichen bzw. den oben angeführten Verfahren drastisch reduziert werden. Aus Kundensicht verfügt das Gerät somit über mehr Ausgangsleistung.

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen in einer schematischen Prinzipskizze:
Figur 1 eine Audioeinrichtung gemäß der Erfindung,
Figur 2 ein Diagramm zur Erläuterung des erfindungsgemäßen Verfahrens.

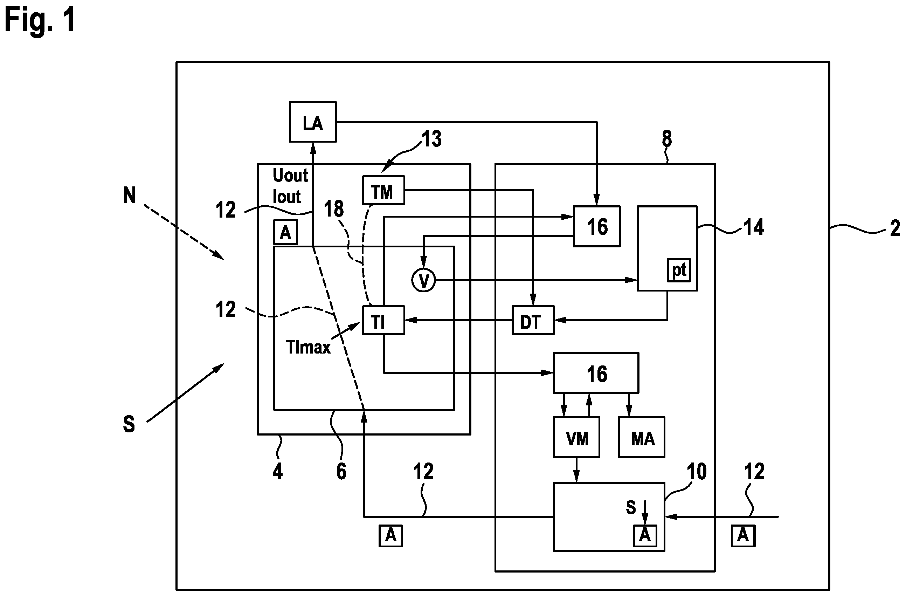

Figur 1 zeigt eine Audioeinrichtung 2. Diese enthält ein Audiogerät 4. Innerhalb, das heißt in seinem Inneren, enthält das Audiogerät 4 eine Komponente 6. Die Komponente 6 weist innerhalb, d.h. in Ihrem Inneren, eine Interntemperatur TI auf, die einer direkten Messung nicht zugänglich ist. Die Komponente 6 ist vor dem Überschreiten einer maximalen Interntemperatur zu schützen, das heißt die Interntemperatur TI soll einen Maximalwert nicht überschreiten. Die Audioeinrichtung 2 enthält außerdem ein Schutzmodul 8. Dieses ist zur Ausführung eines Schutzverfahrens eingerichtet. Das Schutzverfahren wird weiter unten erläutert.

Das Audiogerät 4 ist ein Audioverstärker. Die Audioeinrichtung 2 ist daher eine Verstärkereinrichtung. Das Audiogerät 4 ist eine Endstufe. Die Komponente 6 ist ein zu schützendes Halbleiterbauteil. Die Interntemperatur TI ist eine Sperrschichttemperatur im Halbleiterbauteil. Das Schutzmodul 8 enthält einen Audiolimiter 10. Der Audiolimiter 10 ist in einem Audiopfad 12 stromaufwärts des Audiogerätes 4 angeordnet. Der Audiolimiter 10 ist dazu eingerichtet, ein Audiosignal A, das dem Audiogerät 4 entlang des Audiopfades 12 als Eingangssignal zugeführt wird, in einem Sparbetrieb S zu begrenzen, was durch einen nach unten gerichteten Pfeil angedeutet ist. Das Audiosignal A wird also auf dem Audiopfad 12 geführt. Das Schutzmodul 8 führt folgendes Schutzverfahren durch:

Das Verfahren dient zum Schutz der Komponente 6 innerhalb des Audiogerätes 4 vor dem Überschreiten einer maximalen Interntemperatur TI. Bei dem Verfahren wird eine Verlustleistung V der Komponente 6 ermittelt, welche in Figur 1 durch einen Kreis symbolisch dargestellt ist. Weiterhin wird an bzw. außerhalb der Komponente 6 an einem Messort 13, hier an einem mit der Komponente 6 thermisch gekoppelten, nicht dargestellten Kühlkörper, eine Messtemperatur TM gemessen. Ausgehend von der Verlustleistung V wird mit Hilfe eines thermischen Modells 14 der Komponente 6, welches im Schutzmodul 8 hinterlegt ist, eine Temperaturdifferenz DT für die Komponente 6 ermittelt. Die Temperaturdifferenz DT beschreibt die Differenz der Interntemperatur TI abzüglich der Messtemperatur TM. Die Interntemperatur TI wird nun als Summe der Messtemperatur TM und der Temperaturdifferenz DT zu TI = TM + DT ermittelt. Anhand der Interntemperatur TI und bekannter Komponentendaten 16 der Komponente 6, welche ebenfalls im Schutzmodul 8 hinterlegt sind, wird ein zulässiger Maximalwert VM für die Verlustleistung V ermittelt. Bei einer Verlustleistung V gleich dem Maximalwert VM würde eine maximal erlaubte bzw. gewünschte Interntemperatur TImax erreicht. Im vorliegenden Fall droht eine Überlastung, weshalb das Audiosignal 4 und damit die maximale Ausgangsleistung LA reduziert wird gegenüber dem Normalbetrieb N, wodurch die Interntemperatur TI zwar ihren Maximalwert TImax erreicht, diesen jedoch nicht übersteigt.

Im Falle der Begrenzung des Audiosignals A durch einen Audiolimiter 10 gibt es keine "harte" Unterscheidung zwischen Normalbetrieb N und Sparbetrieb S, weil die maximale Ausgangsleistung LA immer begrenzt wird. Nur der Wert MA der maximalen Ausgangsleistung LA wird stets anhand der aktuellen internen Bauteiltemperatur TI neu ermittelt und somit der Begrenzungswert dem Audiolimiter 10 stets zugeführt.

Die oben genannten Verfahrensschritte werden periodisch durchgeführt. So wird wie oben erläutert periodisch eine interne Sperrschichttemperatur TI ermittelt. Mit Hilfe der Komponentendaten 16 wird periodisch die maximal zulässige Verlustleistung VM der Komponente 6 und daraus die maximal zulässige (Wert MA) Ausgangsleistung LA ermittelt. Aus diesem Wert MA wird dem Audiolimiter 10 ein Begrenzungswert vorgegeben. Liegt also die erwartete Verlustleistung V durch das Audiosignal A vor dem Limiter 10 unter der maximal zulässigen Verlustleistung VM, so wird keinerlei Reduzierung angestrebt. Die Komponente 6 wird dann wieder in einem Normalbetrieb N betrieben (in Figur 1 gestrichelt angedeutet). Im Beispiel wird dann also das Audiosignal A unbegrenzt auf dem Audiopfad 12 dem Audiogerät 4 und damit der Komponente 6 zugeführt.

Die Verlustleistung V wird im Verfahren dadurch ermittelt, dass eine Ausgangsleistung LA der Komponente 6 ermittelt wird und die Verlustleistung V anhand der Ausgangsleistung LA und der bekannten Komponentendaten 16 ermittelt wird. Im Beispiel ist die Ausgangsleistung LA die Leistung des von der Komponente 6 verstärkten Audiosignals A.

In die Ermittlung der Verlustleistung V wird hierbei auch die derzeit ermittelte Interntemperatur TI (nachdem diese das erste Mal ermittelt wurde oder beim ersten Mal z.B. geschätzt wurde, z.B. gleich der Messtemperatur TM) einbezogen.

Aus dem Maximalwert VM für die zulässige Verlustleistung V wird anhand der Komponentendaten 16 ein Maximalwert MA für die zulässige Ausgangsleistung LA der Komponente 6 ermittelt. Im leistungsreduzierten Sparbetrieb S wird die Komponente 6 so betrieben, dass die Ausgangsleistung LA auf den Maximalwert MA begrenzt ist bzw. begrenzt wird.

Die Begrenzung der Verlust- V bzw. der Ausgangsleistung LA im Sparbetrieb S erfolgt also durch die Begrenzung des Audiosignals A mit Hilfe des Audiolimiters 10. Auch durch die Begrenzung der Ausgangsleistung LA wird die Verlustleistung V begrenzt, die über die interne Struktur bzw. Eigenschaften der Komponente 6 mit dieser zusammenhängt. Im Normalbetrieb N erfolgt keine Begrenzung durch den Audiolimiter 10. Das Audiosignal A kann diesen also unverändert passieren, so dass das Audiogerät regulär, d.h. ohne Einschränkungen betrieben wird.

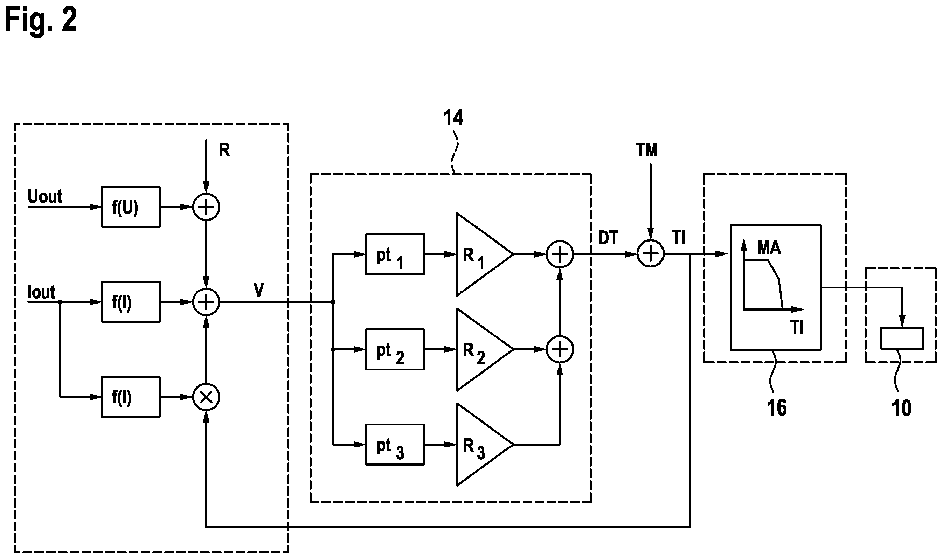

Figur 2 erläutert die Erfindung konkret am Beispiel des Halbleiterschutzes (Schutz der Komponente 6 in Form eines Halbleiters) im Audiogerät 4 in Form eines Audio-Leistungsverstärkers gemäß Figur 1:
1. Ermittlung der Verlustleistung
   (angedeutet durch einen gestrichelten Rahmen)
   Eine Ausgangsspannung Uout und ein Ausgangsstrom lout werden an der Komponente 6 gemessen. Zusammen mit statischen Parametern wie Bauteileigenschaften und internen Betriebsspannungen in Form der Komponentendaten 16 wird abhängig von Ausgangsstrom lout und Ausgangsspannung Uout die Verlustleistung V ermittelt. Ausgangsspannung Uout und Ausgangsstrom lout werden dabei mit nicht näher erläuterten Funktionen f(U) und f(I) modifiziert und die Ergebnisse mit einer Ruheverlustleistung R aufsummiert. Zudem wird hierbei auch die ermittelte (beim ersten Mal wie oben erläutert z.B. geschätzte) Bauteiltemperatur in Form der Interntemperatur TI miteinbezogen, da diese in die Verlustleistung V mit eingeht, die durch den Ausgangsstrom lout erzeugt wird. Dabei wird die Interntemperatur TI mit einer nicht näher erläuterten Funktion f(I) des Ausgangsstromes lout multipliziert und ebenfalls aufsummiert. Somit erfolgt eine Rückführung der ermittelten Sperrschichttemperatur (Interntemperatur TI) auf die Verlustleistungsermittlung.
2. Thermisches Modell
   Anhand der Verlustleistung V wird mit dem thermischen Modell 14 die Erwärmung in Form der Temperaturdifferenz DT berechnet. In diesem Beispiel werden drei Zeitkonstanten pt1-3 (mit nachgeschalteten nicht näher erläuterten Wärmewiderständen R1-3) verwendet, um das dynamische thermische Verhalten einer thermischen Strecke 18, d.h. der Strecke von einer Sperrschicht in der Komponente 6 (Ort der Interntemperatur TI) zu einem nicht dargestellten Temperatursensor (Messort 13 der Messung der Messtemperatur TM) zu beschreiben. In diesem Fall kann die Strecke 18 mit drei Zeitkonstanten pt1-3 ausreichend genau beschrieben werden. In anderen Fällen können auch mehr oder weniger als drei Zeitkonstanten pt genutzt werden, um das dynamische thermische Verhalten der Strecke 18 zu beschreiben.
   Im thermischen Modell 14 werden also 3 thermische Zeitkonstanten pt1-3 und drei thermische Widerstände R1-3 verwendet, die ein dynamisches, thermisches Verhalten der thermischen Strecke 18 beschreiben, die sich zwischen dem Ort der Interntemperatur TI und dem Ort der Messtemperatur TM (Messort 13) erstreckt.
3. Temperaturmessung
   Zusammengerechnet ergeben Erwärmung (Temperaturdifferenz DT) und "Umgebungstemperatur" (Messtemperatur TM) die absolute Sperrschichttemperatur (Interntemperatur TI).
4. Ermittlung der maximal zulässigen Ausgangsleistung
   (angedeutet durch einen gestrichelten Rahmen)
   Aus dem Datenblatt der Komponente 6 (Komponentendaten 16) wird entnommen, bei welcher Interntemperatur TI wie viel Verlustleistung (Maximalwert VM) dem Bauteil (Komponente 6) zugemutet werden darf. Da ja (aus den Komponentendaten 16) bekannt ist, wie der Einfluss der Ausgangsgrößen (Ausgangsstrom lout und -spannung Uout) sich auf die Verlustleistung V im Bauteil (Komponente 6) auswirkt, kann auch von einer zulässigen Verlustleistung VM des Bauteils auf die maximal zulässigen Ausgangsgrößen (Maximalwerte für Uout, lout) gerechnet werden.
5. Reduzierung der Ausgangsleistung
   (angedeutet durch einen gestrichelten Rahmen)
   Mit dem Audio-Limiter 10 wird die Ausgangsleistung LA des Verstärkers (Audiogerät 4) so begrenzt, dass die maximal zulässige Verlustleistung VM im Halbleiter (Komponente 6) nicht überschritten wird. Hierzu wird ein nicht näher erläuterter Schwellwert an den Audiolimiter 10 übergeben.

## Patentansprüche

1. Verfahren zum Schutz einer Komponente (6) innerhalb eines Audiogerätes (4) vor dem Überschreiten einer maximalen Interntemperatur (TI), wobei die Interntemperatur (TI) einer direkten Messung nicht zugänglich ist, bei dem
- eine Komponente (6) geschützt wird, die ein zu schützendes Halbleiterbauteil enthält oder ist, und die Interntemperatur (TI) eine Sperrschichttemperatur im Halbleiterbauteil ist,
- eine Verlustleistung (V) der Komponente (6) ermittelt wird,
- eine Messtemperatur (TM) an der Komponente (6) an einem messtechnisch zugänglichen Messort der Komponente (6) oder in deren Umgebung, der thermisch mit der Interntemperatur (TI) gekoppelt ist, gemessen wird,
- ausgehend von der Verlustleistung (V) mit Hilfe eines thermischen Modells (14) der Komponente (6) eine Temperaturdifferenz (DT) für die Komponente (6) zwischen der Messtemperatur (TM) an der Komponente und der Interntemperatur (TI) innerhalb der Komponente (6) ermittelt wird,
- die Interntemperatur (TI) als Summe der Messtemperatur (TM) und der Temperaturdifferenz (DT) ermittelt wird,
- anhand der Interntemperatur (TM) und bekannter Komponentendaten (16) der Komponente (6) ein zulässiger Maximalwert (VM) für die Verlustleistung (V) ermittelt wird,
- ein Audiosignal (A) derart begrenzt wird, so dass die Verlustleistung (V) den Maximalwert (VM) nicht übersteigt und die maximale Interntemperatur (TI) nicht überschritten wird.

2. Verfahren nach Anspruch 1, **dadurch gekennzeichnet, dass** die Verlustleistung (V) dadurch ermittelt wird, dass die Ausgangsleistung (LA) der Komponente (6) ermittelt wird und die Verlustleistung (V) anhand der Ausgangsleistung (LA) und der bekannten Komponentendaten (16) ermittelt wird

3. Verfahren nach einem der vorhergehenden Ansprüche, **dadurch gekennzeichnet, dass** die Verlustleistung (V) auch anhand der Interntemperatur (TI) und/oder der Messtemperatur (TM) ermittelt wird.

4. Verfahren nach einem der vorhergehenden Ansprüche, **dadurch gekennzeichnet, dass** im thermischen Modell (14) mindestens eine thermische Zeitkontante (pt) verwendet wird, die ein dynamisches thermisches Verhalten einer thermische Strecke (18) zwischen dem Ort der Interntemperatur (TI) und dem Messort (13) der Messtemperatur (TM) beschreibt.

5. Verfahren nach einem der vorhergehenden Ansprüche, **dadurch gekennzeichnet, dass** aus dem Maximalwert (VM) für die zulässige Verlustleistung (V) anhand der Komponentendaten (16) ein Maximalwert (MA) für eine zulässige Ausgangsleistung (LA) der Komponente (6) ermittelt wird, und die Komponente (6) im leistungsreduzierten Sparbetrieb (S) so betrieben wird, dass die Ausgangsleistung (LA) auf den zugehörigen Maximalwert (MA) begrenzt wird.

6. Verfahren nach einem der vorhergehenden Ansprüche, **dadurch gekennzeichnet, dass** im Sparbetrieb (S) die Verlustleistung (V) mit Hilfe eines in einem Audiopfad (12) stromaufwärts der Komponente (6) angeordneten Audiolimiters (10) auf den Maximalwert (VM) begrenzt wird, indem ein auf dem Audiopfad (12) geführtes Audiosignal (A) als Eingangssignal in die Komponente (6) begrenzt wird.

7. Audioeinrichtung (2), mit einem Audiogerät (4), das innerhalb eine Komponente (6) enthält, die vor dem Überschreiten einer maximalen Interntemperatur (TI) zu schützen ist, wobei die Interntemperatur (TI) einer direkten Messung nicht zugänglich ist, wobei die Komponente (6) ein zu schützendes Halbleiterbauteil enthält oder ist, und die Interntemperatur (TI) eine Sperrschichttemperatur im Halbleiterbauteil ist, und mit einem Schutzmodul (8) zur Ausführung des folgenden Verfahrens, insbesondere zur Ausführung eines Verfahrens nach einem der vorhergehenden Ansprüche:
- Ermittlung einer Verlustleistung (V) der Komponente (6),
- Messung einer Messtemperatur (TM) an der Komponente (6) an einem messtechnisch zugänglichen Messort der Komponente (6) oder in deren Umgebung, der thermisch mit der Interntemperatur (TI) gekoppelt ist,
- Ermittlung einer Interntemperatur (TI) ) innerhalb der Komponente (6) mit Hilfe eines thermischen Modells (14) der Komponente (6) ausgehend von der ermittelten Verlustleistung (V) und der gemessenen Messtemperatur (TM),
- Ermittlung eines zulässigen Maximalwerts (VM) für die Verlustleistung (V) anhand der Interntemperatur (TM) und bekannter Komponentendaten (16) der Komponente (6),
- Begrenzung eines Audiosignal (A) derart, so dass die Verlustleistung (V) einen Maximalwert (VM) nicht übersteigt und/oder die maximale Interntemperatur nicht überschritten wird.

8. Audioeinrichtung (2) nach Anspruch 7, **dadurch gekennzeichnet, dass** das Audiogerät (4) und/oder die Audioeinrichtung (2) ein Audioverstärker ist.

9. Audioeinrichtung (2) nach einem der Ansprüche 7 bis 8, **dadurch gekennzeichnet, dass** das Schutzmodul (8) einen Audiolimiter (10) enthält, der in einem Audiopfad (12) stromaufwärts des Audiogerätes (4) angeordnet ist und der dazu eingerichtet ist, ein auf dem Audiopfad (12) geführtes Audiosignal (A) als Eingangssignal in das Audiogerät (4) im Sparbetrieb (S) zu begrenzen.

## Claims

1. A method for protecting a component (6) inside an audio appliance (4) against the exceeding of a maximum internal temperature (TI), whereby the internal temperature (TI) cannot be measured directly, in which
- a component (6) is protected that contains or is a semiconductor device to be protected and the internal temperature (TI) is the temperature of a barrier layer in the semiconductor device,
- a power loss (V) of the component (6) is determined,
- a measured temperature (TM) is measured at the component (6) at a measurement location of the component (6) that is accessible for measurement or in its vicinity, which is thermally coupled to the internal temperature (TI),
- a temperature difference (DT) for the component (6) between the measured temperature (TM) at the component (6) and the internal temperature (TI) is determined from the power loss (V) with the aid of a thermal model (14) of the component (6),
- the internal temperature (TI) is determined as the sum of the measured temperature (TM) and the temperature difference (DT),
- a permissible maximum value (VM) for the power loss (V) is determined using the internal temperature (TM) and known component data (16) of the component (6),
- an audio signal (A) is limited such that the power loss (V) does not exceed the maximum value (VM) and the maximum internal temperature is not exceeded.

2. The method as claimed in claim 1, **characterized in that** the power loss (V) is determined by virtue of the output power (LA) of the component (6) being determined and the power loss (V) being determined on the basis of the output power (LA) and the known component data (16).

3. The method according to any of the preceding claims, **characterized in that** the power loss (V) is also determined on the basis of the internal temperature (TI) and/or the measured temperature (TM).

4. The method according to any of the preceding claims, **characterized in that** at least one thermal time constant (pt) describing a dynamic thermal behavior of a thermal length (18) between the location of the internal temperature (TI) and the measurement location (13) of the measured temperature (TM) is used in the thermal model (14).

5. The method according to any of the preceding claims, **characterized in that** the component data (16) are used to determine a maximum value (MA) for a permissible output power (LA) of the component (6) from the maximum value (VM) for the permissible power loss (V), and the component (6) is operated in the reduced-power economy mode (S) such that the output power (LA) is limited to the associated maximum value (MA).

6. The method according to any of the preceding claims, **characterized in that** in the economy mode (S), the power loss (V) is limited to the maximum value (VM) using an audio limiter (10) arranged in an audio path (12) upstream of the component (6), **in that** an audio signal (A) carried on the audio path (12) is limited as an input signal into the component (6).

7. An audio device (2) having an audio appliance (4) that has a component (6) inside to be protected against the exceeding of a maximum internal temperature (TI), the internal temperature (TI) not being accessible to direct measurement, the component (6) containing or being a semiconductor device to be protected and the internal temperature (TI) being a temperature of a barrier layer in the semiconductor device, and having a protection module (8) for carrying out the method that follows, in particular for carrying out the method according to any of the preceding claims:
- determining a power loss (V) of the component (6),
- measuring a measured temperature (TM) at the component (6) at a measurement location of the component (6) that is accessible for measurement or in its vicinity, which is thermally coupled to the internal temperature (TI),
- determining an internal temperature (TI) within the component (6) using a thermal model (14) of the component (6) from the determined power loss (V) and the measured temperature (TM),
- determining a permissible maximum value (VM) for the power loss (V) on the basis of the internal temperature (TI) and known component data (16) of the component (6),
- limiting an audio signal (A) such that the power loss (V) does not exceed a maximum value (VM) and/or the maximum internal temperature is not exceeded.

8. The audio device (2) according to claim 7, **characterized in that** the audio appliance (4) and/or the audio device (2) is an audio amplifier.

9. The audio device (2) according to any of preceding claims 7 to 8, **characterized in that** the protection module (8) contains an audio limiter (10) that is arranged in an audio path (12) upstream of the audio appliance (4) and that is configured to limit an audio signal (A) carried on the audio path (12) as an input signal into the audio appliance (4) in the economy mode (S).

## Revendications

1. Procédé de protection d'un composant (6) à l'intérieur d'un appareil audio (4) contre le dépassement d'une température interne (TI) maximale, dans lequel la température interne (TI) n'est pas accessible à une mesure directe, pour lequel
- un composant (6) qui contient ou est un composant semi-conducteur à protéger est protégé, et la température interne (TI) est une température de couche de blocage dans le composant semi-conducteur,
- une dissipation de puissance (V) du composant (6) est déterminée,
- une température de mesure (TM) est mesurée sur le composant (6) au niveau d'un emplacement de mesure du composant (6) accessible à la mesure ou dans son environnement, emplacement qui est couplé thermiquement à la température interne (TI),
- une différence de température (DT) pour le composant (6) entre la température de mesure (TM) sur le composant et la température interne (TI) à l'intérieur du composant (6) est déterminée à partir de la dissipation de puissance (V) à l'aide d'un modèle thermique (14) du composant (6),
- la température interne (TI) est déterminée comme somme de la température de mesure (TM) et de la différence de température (DT),
- une valeur maximale (VM) autorisée pour la dissipation de puissance (V) est déterminée à l'aide de la température interne (TM) et des données (16) connues du composant (6),
- un signal audio (A) est limité de telle manière que la dissipation de puissance (V) ne dépasse pas la valeur maximale (VM) et que la température interne maximale (TI) ne soit pas dépassée.

2. Procédé selon la revendication 1, **caractérisé en ce que** la dissipation de puissance (V) est déterminée par le fait que la puissance de sortie (LA) du composant (6) soit déterminée et la dissipation de puissance (V) est déterminée à l'aide de la puissance de sortie (LA) et des données de composant (16) connues.

3. Procédé selon l'une quelconque des revendications précédentes, **caractérisé en ce que** la dissipation de puissance (V) est aussi déterminée à l'aide de la température interne (TI) et/ou de la température de mesure (TM).

4. Procédé selon l'une quelconque des revendications précédentes, **caractérisé en ce qu'**au moins une constante de temps (pt) thermique est utilisée dans le modèle thermique (14), constante qui décrit un comportement thermique dynamique d'un parcours thermique (18) entre l'emplacement de la température interne (TI) et l'emplacement de mesure (13) de la température de mesure (TM).

5. Procédé selon l'une quelconque des revendications précédentes, **caractérisé en ce qu'**une valeur maximale (MA) pour une puissance de sortie (LA) autorisée du composant (6) est déterminée à partir de la valeur maximale (VM) pour la dissipation de puissance (V) autorisée à l'aide des données de composant (16), et le composant (6) fonctionne en mode économie (S) puissance réduite de sorte que la puissance de sortie (LA) soit limitée à la valeur maximale afférente (MA).

6. Procédé selon l'une quelconque des revendications précédentes, **caractérisé en ce qu'**en mode économie (S), la dissipation de puissance (V) est limitée à la valeur maximale (VM) à l'aide d'un limiteur audio (10) agencé dans une voie audio (12) en amont du composant (6), **en ce qu'**un signal audio (A) guidé sur la voie audio (12) est limité comme signal d'entrée dans le composant (6).

7. Système audio (2), avec un appareil audio (4) qui contient à l'intérieur un composant (6) qui doit être protégé contre le dépassement d'une température interne (TI) maximale, dans lequel la température interne (TI) n'est pas accessible à une mesure directe, dans lequel le composant (6) contient ou est un composant semi-conducteur à protéger, et la température interne (TI) est une température de couche de blocage dans le composant semi-conducteur, et avec un module de protection (8) pour la réalisation du procédé suivant, en particulier pour la réalisation d'un procédé selon l'une quelconque des revendications précédentes :
- la détermination d'une dissipation de puissance (V) du composant (6),
- la mesure d'une température de mesure (TM) sur le composant (6) au niveau d'un emplacement de mesure accessible à la mesure du composant (6) ou dans son environnement, emplacement qui est couplé thermiquement à la température interne (TI),
- la détermination d'une température interne (TI) à l'intérieur du composant (6) à l'aide d'un modèle thermique (14) du composant (6) à partir de la dissipation de puissance (V) déterminée et de la température de mesure (TM) mesurée,
- la détermination d'une valeur maximale (VM) autorisée pour la dissipation de puissance (V) à l'aide de la température interne (TM) et de données (16) connues du composant (6),
- la limitation d'un signal audio (A) de telle manière que la dissipation de puissance (V) ne dépasse pas la valeur maximale (VM) et/ou la température interne maximale ne soit pas dépassée.

8. Système audio (2) selon la revendication 7, **caractérisé en ce que** l'appareil audio (4) et/ou le système audio (2) est un amplificateur audio.

9. Système audio (2) selon l'une quelconque des revendications 7 à 8, **caractérisé en ce que** le module de protection (8) contient un limiteur audio (10) qui est agencé dans une voie audio (12) en amont de l'appareil audio (4) et qui est conçu afin de limiter un signal audio (A) guidé sur la voie audio (12) comme signal d'entrée dans l'appareil audio (4) en mode économie (S).
